(19) Europäisches Patentamt
European Patent Office
Office européen des brevets

(11) **EP 2 587 548 A1**

(12) **EUROPEAN PATENT APPLICATION**
published in accordance with Art. 153(4) EPC

(43) Date of publication:
**01.05.2013 Bulletin 2013/18**

(51) Int Cl.:
***H01L 31/04*** *(2006.01)*

(21) Application number: **11798087.0**

(22) Date of filing: **20.06.2011**

(86) International application number:
**PCT/JP2011/064048**

(87) International publication number:
**WO 2011/162203 (29.12.2011 Gazette 2011/52)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.06.2010 JP 2010143249**

(71) Applicant: **Sharp Kabushiki Kaisha
Osaka-shi, Osaka 545-8522 (JP)**

(72) Inventor: **IMOTO, Junpei
Osaka-shi
Osaka 545-8522 (JP)**

(74) Representative: **Müller - Hoffmann & Partner
Patentanwälte
Innere Wiener Strasse 17
81667 München (DE)**

(54) **SOLAR CELL**

(57)     Disclosed is a solar cell (1) wherein a diffusion region (4) containing an impurity of a second conductivity type provided on a light-receiving surface side of a silicon substrate (2) containing an impurity of a first conductivity type has a first diffusion region (5) and second diffusion regions (6). Surfaces of the second diffusion regions (6) are higher in concentration of the impurity of the second conductivity type than a surface of the first diffusion region (5). The second diffusion regions (6) are arranged spaced apart from one another. A light-receiving surface electrode (8) is connected to a plurality of the second diffusion regions (6).

FIG.3

## Description

TECHNICAL FIELD

The present invention relates to a solar cell, and more particularly to a structure of a light-receiving surface side of a solar cell.

BACKGROUND ART

A solar cell is an element that converts solar energy directly into electrical energy. Since the solar cell easily harmonizes with the environment and its energy source is solar energy, it can be said that its energy source is infinite. Furthermore, the solar cell is also advantageous in having a long life. The solar cell includes a crystalline silicon solar cell, a compound semiconductor solar cell, and the like.

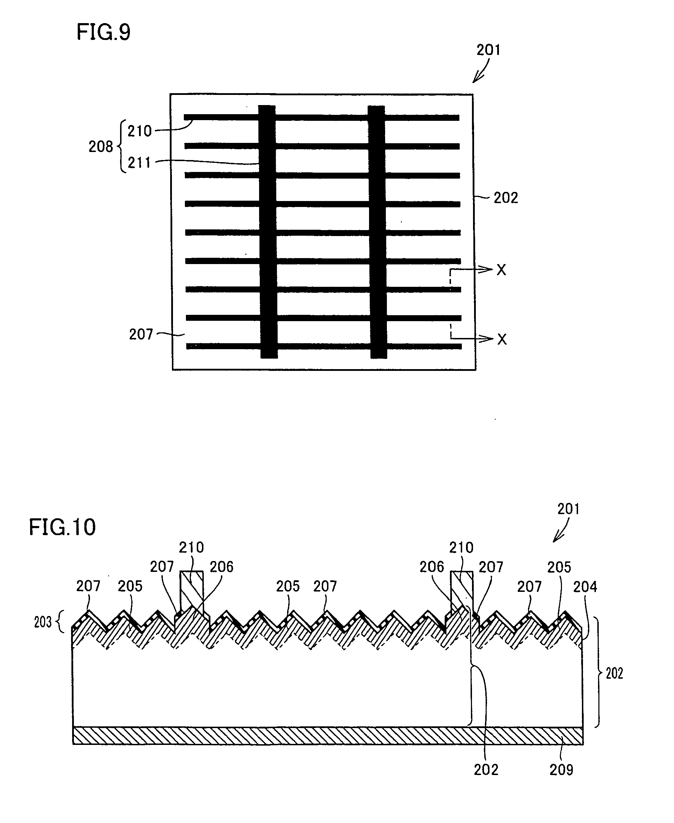

Fig. 9 is a schematic plan view of a solar cell described in conventional Non-Patent Literature 1 (Thomas Lauermann et al., "INSECT: AN INLINE SELECTIVE EMITTER CONCEPT WITH HIGH EFFICIENCIES AT COMPETITIVE PROCESS COSTS IMPROVED WITH INKJET MASKING TECHNOLOGY.", 24th EU PVSEC Hamburg, September 21-25, 2009) as seen from the light-receiving surface side, and Fig. 10 is a schematic sectional view taken along the line X-X of Fig. 9. As shown in Fig. 9, formed on the light-receiving surface of a solar cell 201 is a light-receiving surface electrode 208 formed of a subgrid electrode 210 and a main grid electrode 211 crossing subgrid electrode 210. An antireflection film 207 is also formed on the light-receiving surface of solar cell 201.

Moreover, as shown in Fig. 10, an uneven structure 203 as a textured structure is formed on the light-receiving surface of a p-type silicon substrate 202 of solar cell 201, and an n-type impurity diffusion region 204 is formed all over the light-receiving surface of p-type silicon substrate 202.

N-type impurity diffusion region 204 has an n-type impurity first diffusion region 205 and an n-type impurity second diffusion region 206. The concentration of an n-type impurity in the surface of n-type impurity first diffusion region 205 is lower than the concentration of the n-type impurity in the surface of n-type impurity second diffusion region 206.

The light-receiving surface of n-type impurity diffusion region 204 is covered with antireflection film 207, and subgrid electrode 210 is formed to be in contact with n-type impurity second diffusion region 206. A rear electrode 209 is formed on the rear surface of p-type silicon substrate 202 on the opposite side of the light-receiving surface.

N-type impurity diffusion region 204 is formed by doping the light-receiving surface of p-type silicon substrate 202 with the n-type impurity. At this time, from the viewpoint of reducing contact resistance between light-receiving surface electrode 208 and n-type impurity diffusion region 204, it is preferable that the concentration of the n-type impurity in n-type impurity diffusion region 204 be high.

On the other hand, from the viewpoint of reducing recombination of electron and hole in the light-receiving surface of solar cell 201, it is preferable that the concentration of the n-type impurity in n-type impurity diffusion region 204 be low.

That is, when the concentration of the n-type impurity in n-type impurity diffusion region 204 is excessively low, an increase in contact resistance between light-receiving surface electrode 208 and n-type impurity diffusion region 204, namely, an increase in series resistance will be incurred. On the other hand, when a reduction in the concentration of the n-type impurity in n-type impurity diffusion region 204 is insufficient, the effect of reducing recombination of electron and hole in the light-receiving surface of solar cell 201 will be lowered.

Therefore, in n-type impurity diffusion region 204, by making the concentration of the n-type impurity in n-type impurity second diffusion region 206 as a region in contact with light-receiving surface electrode 208 higher than that in n-type impurity first diffusion region 205 as a remaining region, solar cell 201 is obtained in which recombination of electron and hole in n-type impurity first diffusion region 205 is reduced while minimizing contact resistance between light-receiving surface electrode 208 and n-type impurity second diffusion region 206.

NPL 1 also discloses a method for manufacturing solar cell 201 described above by a simple method that a complicated step, such as photolithography, is not required.

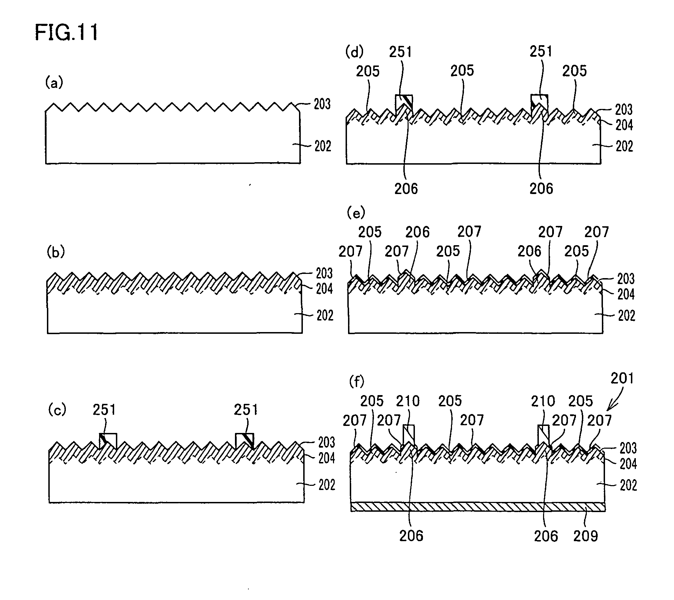

Schematic sectional views illustrating the method for manufacturing solar cell 201 described in conventional NPL 1 are shown in Figs. 11(a) to 11(f). Hereinbelow, referring to Figs. 11(a) to 11(f), the method for manufacturing solar cell 201 described in conventional NPL 1 will be explained.

First, as shown in Fig. 11(a), uneven structure 203 is formed on a surface on the side to be a light-receiving surface (hereinafter referred to as a "light-receiving surface") of p-type silicon substrate 202.

Next, as shown in Fig. 11(b), by vapor phase diffusion using $POCl_3$, phosphorus is diffused into the light-receiving surface of p-type silicon substrate 202 to form n-type impurity diffusion region 204. Since n-type impurity diffusion region 204 is an impurity diffusion layer, the concentration gradient is formed in which a phosphorus concentration gradually decreases from the light-receiving surface of p-type silicon substrate 202 toward the inside.

Next, as shown in Fig. 11(c), an acid-resistant mask 251 is formed in a region of the light-receiving surface of p-type silicon substrate 202 of uneven structure 203 where light-receiving surface electrode 208 is to be disposed.

Next, as shown in Fig. 11(d), etching is performed on the light-receiving surface side of p-type silicon substrate 202. Accordingly, a portion of n-type impurity diffusion region 204 that is not protected by acid-resistant mask 251 is etched to form n-type impurity first diffusion region 205. Since a portion of n-type impurity diffusion region 204 that is protected by acid-resistant mask 251 is not etched at this time, n-type impurity second diffusion region 206 having a surface lower in sheet resistance than the surface of n-type impurity first diffusion region 205 is formed. This is because the concentration gradient in which the phosphorus concentration gradually decreases from the light-receiving surface of p-type silicon substrate 202 toward the inside is formed as described above.

Next, as shown in Fig. 11(e), acid-resistant mask 251 is removed from the light-receiving surface of p-type silicon substrate 202 to form antireflection film 207 made of a silicon nitride film on the light-receiving surface of p-type silicon substrate 202.

Next, as shown in Fig. 11(f), light-receiving surface electrode 208 is formed to come into contact with n-type impurity second diffusion region 206 exposed by removing a part of antireflection films 207, and rear electrode 209 is formed on the rear surface of p-type silicon substrate 202, thereby forming solar cell 201.

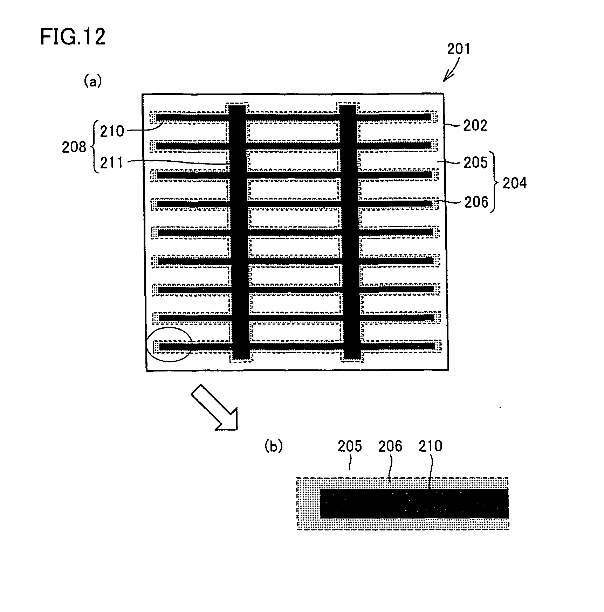

A schematic plan view of p-type silicon substrate 202 as seen from the light-receiving surface side with antireflection film 207 formed on the light-receiving surface of solar cell 201 described in conventional NPL 1 having been removed is shown in Fig. 12(a), and a schematic enlarged plan view of and around an end of subgrid electrode 210 shown in Fig. 12(a) is shown in Fig. 12(b).

As shown in Figs. 12(a) and 12(b), n-type impurity second diffusion region 206 and light-receiving surface electrode 208 have the same planar shape, however, n-type impurity second diffusion region 206 has an area larger than the formation area of light-receiving surface electrode 208, and light-receiving surface electrode 208 is formed within n-type impurity second diffusion region 206.

CITATION LIST

NON PATENT LITERATURE

NPL 1: Thomas Lauermann et al., "INSECT: AN INLINE SELECTIVE EMITTER CONCEPT WITH HIGH EFFICIENCIES AT COMPETITIVE PROCESS COSTS IMPROVED WITH INKJET MASKING TECHNOLOGY.", 24th EU PVSEC Hamburg, September 21-25, 2009

SUMMARY OF INVENTION

TECHNICAL PROBLEM

As described above, in the method for manufacturing solar cell 201 of NPL 1, n-type impurity first diffusion region 205 and n-type impurity second diffusion region 206 are formed by diffusing phosphorus as an n-type impurity into the light-receiving surface of p-type silicon substrate 202 in a single diffusion step.

However, the method for manufacturing solar cell 201 of NPL 1 raises problems in that a displacement of light-receiving surface electrode 208 relative to n-type impurity second diffusion region 206 occurs when forming light-receiving surface electrode 208, and light-receiving surface electrode 208 is not formed on n-type impurity second diffusion region 206, so that series resistance increases and conversion efficiency is reduced.

In view of the above-described circumstances, the present invention has an object to provide a solar cell capable of suppressing a reduction in conversion efficiency that would be caused by a displacement of a light-receiving surface electrode.

SOLUTION TO PROBLEM

According to an aspect of the present invention, a solar cell includes a silicon substrate containing an impurity of a first conductivity type, a diffusion region containing an impurity of a second conductivity type provided on a light-receiving surface side of the silicon substrate, and a light-receiving surface electrode provided on the light-receiving surface side of the diffusion region. The diffusion region has a first diffusion region and second diffusion regions. Surfaces of the second diffusion regions are higher in concentration of the impurity of the second conductivity type than a surface of the first diffusion region. The second diffusion regions are arranged spaced apart from one another. The light-receiving surface electrode is connected to a plurality of the second diffusion regions.

Here, according to an aspect of solar cell of the present invention, the light-receiving surface electrode may be formed of a main grid electrode and a subgrid electrode, and the subgrid electrode may be connected to the plurality of the second diffusion regions.

According to an aspect of solar cell of the present invention, the subgrid electrode may cross the main grid electrode.

According to an aspect of solar cell of the present invention, the second diffusion regions may have a rectangular shape.

According to an aspect of solar cell of the present invention, when a crossing rate Z of the second diffusion regions is expressed by the following expression (I): the crossing rate Z

$$(\%) = 100 \times X/Y \qquad \ldots (I)$$

where X represents a length of the second diffusion regions in a longitudinal direction of the subgrid electrode, and Y represents a pitch between the second diffusion regions in the longitudinal direction of the subgrid electrode, the crossing rate Z of the second diffusion regions may be less than or equal to 20%.

According to an aspect of solar cell of the present invention, the second diffusion regions may each have a protruding portion protruding in the longitudinal direction of the subgrid electrode.

According to an aspect of the present invention, a solar cell includes a silicon substrate containing an impurity of a first conductivity type, a diffusion region containing an impurity of a second conductivity type provided on a light-receiving surface side of the silicon substrate, and a light-receiving surface electrode provided on the light-receiving surface side of the diffusion region. The diffusion region has a first diffusion region and second diffusion regions. Surfaces of the second diffusion regions are higher in concentration of the impurity of the second conductivity type than a surface of the first diffusion region. The light-receiving surface electrode is formed of a main grid electrode and a subgrid electrode. The second diffusion regions have regions in contact with the subgrid electrode. The second diffusion regions each have a protruding portion protruding in a direction orthogonal to a longitudinal direction of the subgrid electrode.

According to an aspect of solar cell of the present invention, the subgrid electrode may cross the main grid electrode.

Furthermore, according to an aspect of solar cell of the present invention, the second conductivity type may be an n-type.

ADVANTAGEOUS EFFECTS OF INVENTION

According to the present invention, a solar cell capable of suppressing a reduction in conversion efficiency that would be caused by a displacement of a light-receiving surface electrode can be provided.

BRIEF DESCRIPTION OF DRAWINGS

Fig. 1 is a schematic plan view of a solar cell of a first embodiment as seen from its light-receiving surface.

Fig. 2 is a schematic sectional view taken along the line II-II of Fig. 1.

Fig. 3(a) is a schematic plan view of a p-type silicon substrate as seen from the light-receiving surface side with an antireflection film formed on the light-receiving surface of the solar cell of the first embodiment having been removed, and Fig. 3(b) is a schematic enlarged plan view of and around an end of a subgrid electrode shown in Fig. 3(a).

Figs. 4(a) to (f) are schematic sectional views illustrating an example of a method for manufacturing the solar cell of the first embodiment.

Fig. 5(a) is a schematic enlarged plan view illustrating the relationship between the subgrid electrode and n-type impurity second diffusion regions of the solar cell of the first embodiment, and Fig. 5(b) is a schematic enlarged plan view illustrating the relationship between a subgrid electrode and n-type impurity second diffusion regions of a solar cell of a control.

Fig. 6(a) is a schematic plan view of a p-type silicon substrate as seen from the light-receiving surface side with an antireflection film formed on the light-receiving surface of a solar cell of a second embodiment having been removed, and Fig. 6(b) is a schematic enlarged plan view of and around an end of a subgrid electrode shown in Fig. 6(a).

Fig. 7(a) is a schematic plan view of a p-type silicon substrate as seen from the light-receiving surface side with an antireflection film formed on the light-receiving surface of a solar cell of a third embodiment having been removed, and Fig. 7(b) is a schematic enlarged plan view of and around an end of a subgrid electrode shown in Fig. 7(a).

Fig. 8(a) is a schematic plan view of a p-type silicon substrate as seen from the light-receiving surface side with an antireflection film formed on the light-receiving surface of a solar cell of a fourth embodiment having been removed, and Fig. 8(b) is a schematic enlarged plan view of and around an end of a subgrid electrode shown in Fig. 8(a).

Fig. 9 is a schematic plan view of a conventional solar cell described in NPL 1 as seen from the light-receiving surface side.

Fig. 10 is a schematic sectional view taken along the line X-X of Fig. 9.

Figs. 11 (a) to (f) are schematic sectional views illustrating a method for manufacturing the conventional solar cell described in NPL 1.

Fig. 12(a) is a schematic plan view of a p-type silicon substrate as seen from the light-receiving surface side with an antireflection film formed on the light-receiving surface of the conventional solar cell described in NPL 1 having been removed, and Fig. 12(b) is a schematic enlarged plan view of and around an end of a subgrid electrode shown in Fig. 12(a).

## DESCRIPTION OF EMBODIMENTS

Hereinbelow, embodiments of the present invention will be described. It is noted that, in the drawings of the present invention, the same reference character shall represent the same portion or a corresponding portion.

<First Embodiment>

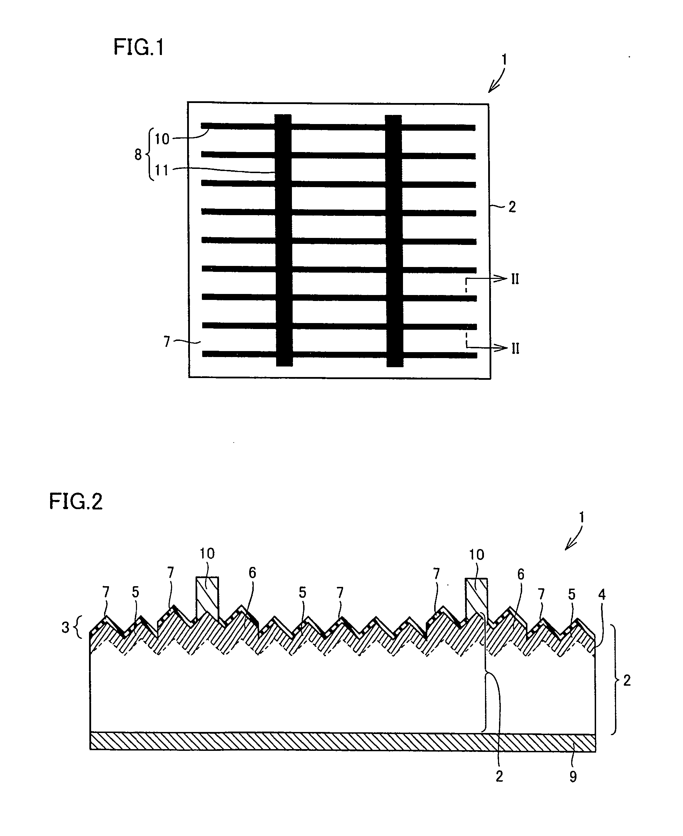

A schematic plan view of a solar cell of a first embodiment as seen from its light-receiving surface is shown in Fig. 1. As shown in Fig. 1, an antireflection film 7 and a light-receiving surface electrode 8 are formed on the light-receiving surface of a p-type silicon substrate 2 of a solar cell 1. Antireflection film 7 is made of a silicon nitride film or the like, for example. Light-receiving surface electrode 8 is formed of a subgrid electrode 10 and a main grid electrode 11, and subgrid electrode 10 and main grid electrode 11 both have a rectangular surface shape.

Here, the longitudinal direction of subgrid electrode 10 and the longitudinal direction of main grid electrode 11 make an angle of about 90°, and subgrid electrode 10 crosses main grid electrode 11.

A schematic sectional view taken along the line II-II of Fig. 1 is shown in Fig. 2. An uneven structure 3 as a textured structure is formed on the light-receiving surface side of p-type silicon substrate 2, and an n-type impurity diffusion region 4 as an n-type impurity diffusion layer is formed on the light-receiving surface of p-type silicon substrate 2. Here, n-type impurity diffusion region 4 has an n-type impurity first diffusion region 5 and an n-type impurity second diffusion region 6. The concentration of an n-type impurity in the surface of n-type impurity second diffusion region 6 is higher than the concentration of the n-type impurity in the surface of n-type impurity first diffusion region 5.

In addition, subgrid electrode 10 is formed to come into contact with a part of the surface of n-type impurity second diffusion region 6, and a rear electrode 9 is formed on the rear surface of p-type silicon substrate 2 at the opposite side of the light-receiving surface. It is noted that the thickness of p-type silicon substrate 2 is about 200 μm, for example, and the width and length of the light-receiving surface of p-type silicon substrate 2 are both about 156.5 mm, for example.

Furthermore, since the thickness of p-type silicon substrate 2 in n-type impurity second diffusion region 6 is thicker than the thickness of p-type silicon substrate 2 in n-type impurity first diffusion region 5, n-type impurity second diffusion region 6 will have a protruding portion formed along the longitudinal direction of subgrid electrode 10 (the direction normal to the sheet of drawing of Fig. 2).

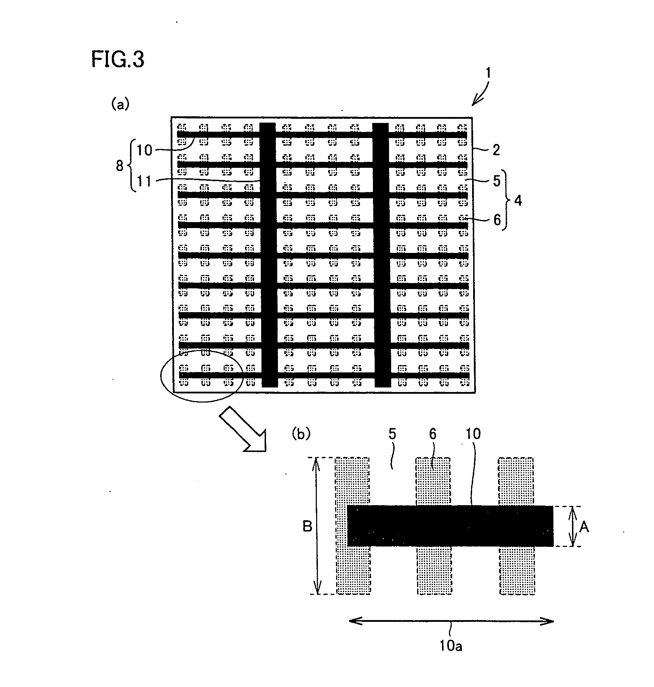

A schematic plan view of p-type silicon substrate 2 as seen from the light-receiving surface side with antireflection film 7 formed on the light-receiving surface of solar cell 1 having been removed is shown in Fig. 3(a), and a schematic enlarged plan view of and around an end of subgrid electrode 10 shown in Fig. 3(a) is shown in Fig. 3(b).

As shown in Fig. 3(a), n-type impurity diffusion region 4 is formed substantially all over the light-receiving surface of p-type silicon substrate 2, and n-type impurity second diffusion regions 6 having a rectangular surface are arranged spaced apart from one another in the form of a plurality of islands.

As shown in Fig. 3(b), subgrid electrode 10 is electrically connected to the plurality of n-type impurity second diffusion regions 6 along a longitudinal direction 10a thereof.

Here, it is preferable that a length B of n-type impurity second diffusion region 6 in the longitudinal direction be more than or equal to three times and less than or equal to five times a width A representing the length of subgrid electrode 10 in the direction orthogonal to longitudinal direction 10a. In this case, by suppressing an increase in the formation area of n-type impurity second diffusion regions 6 while ensuring electric connection between n-type impurity second diffusion regions 6 and subgrid electrode 10, recombination of electron and hole in the light-receiving surface of solar cell 1 can be reduced, so that a reduction in conversion efficiency of solar cell 1 can be suppressed.

It is noted that width A of subgrid electrode 10 can be 100 μm, for example, and length B of n-type impurity second diffusion region 6 can be 500 μm, for example.

Although the case where the surface shape of n-type impurity second diffusion region 6 is rectangular has been described above, the surface shape of n-type impurity second diffusion region 6 is not limited to the rectangular shape, but may be elliptical, for example.

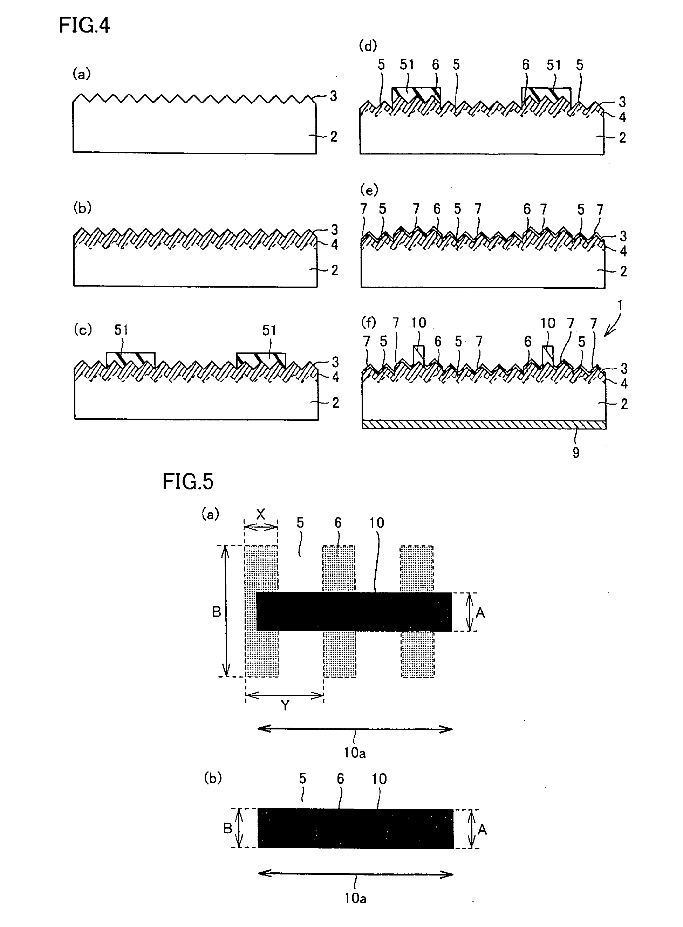

Referring to schematic sectional views of Figs. 4(a) to 4(f), an example of the method for manufacturing solar cell 1 of the first embodiment will be described below.

First, as shown in Fig. 4(a), p-type silicon substrate 2 whose light-receiving surface has a width and a length of both about 156.5 mm and a thickness of about 200 $\mu$m, for example, is prepared, and uneven structure 3 is formed on the light-receiving surface of p-type silicon substrate 2.

Next, as shown in Fig. 4(b), by performing vapor phase diffusion of phosphorus into the light-receiving surface of p-type silicon substrate 2 using $POCl_3$, n-type impurity diffusion region 4 is formed. Since n-type impurity diffusion region 4 is a diffusion layer of phosphorus which is an n-type impurity, the concentration gradient of phosphorus concentration in which the phosphorus concentration gradually decreases from the light-receiving surface of p-type silicon substrate 2 toward the inside is formed. Then, a glass layer formed on the light-receiving surface of p-type silicon substrate 2 when phosphorus is diffused is removed by a hydrofluoric acid treatment.

Next, for concentration control of the n-type impurity in the surface of n-type impurity diffusion region 4, the sheet resistance of the light-receiving surface of p-type silicon substrate 2 is measured by a four probe method. Here, the sheet resistance of the light-receiving surface of p-type silicon substrate 2 is controlled to fall within the range between more than or equal to 30Ω/ and less than or equal to 60 Ω/ , for example. Although the method for controlling the concentration of the n-type impurity in the surface of n-type impurity diffusion region 4 also includes a method using SIMS (Secondary Ion-microprobe Mass Spectrometry) and the like, the method for measuring the sheet resistance is simple.

The sheet resistance of the surface of n-type impurity diffusion region 4 is not particularly limited provided that the contact resistance with light-receiving surface electrode 8 to be formed in a subsequent step is sufficiently low, but an optimum value varies depending on the composition, formation conditions, and the like of light-receiving surface electrode 8.

Next, as shown in Fig. 4(c), an acid-resistant mask 51 is formed in a region of the surface of n-type impurity diffusion region 4 where light-receiving surface electrode 8 is to be disposed. N-type impurity diffusion region 4 with acid-resistant mask 51 formed thereon will be left as n-type impurity second diffusion region 6 in a subsequent step. The method for forming acid-resistant mask 51 includes a method using photolithography, a method using a printing method such as screen printing, or a method using ink jet, for example.

Next, as shown in Fig. 4(d), the light-receiving surface of p-type silicon substrate 2 is etched. Accordingly, a portion of n-type impurity diffusion region 4 that is not protected by acid-resistant mask 51 is etched, so that n-type impurity first diffusion region 5 whose surface has a sheet resistance of about 90 Ω/ , for example, is formed. A portion of n-type impurity diffusion region 4 that is protected by acid-resistant mask 51 is not etched at this time, and n-type impurity second diffusion region 6 whose surface has a sheet resistance lower than that of the surface of n-type impurity first diffusion region 5 formed by etching is formed. This is because, as described above, the concentration gradient of phosphorous concentration in which the phosphorus concentration gradually decreases from the light-receiving surface of p-type silicon substrate 2 toward the inside is formed.

Next, as shown in Fig. 4(e), acid-resistant mask 51 is removed from p-type silicon substrate 2, and then antireflection film 7 made of a silicon nitride film or the like, for example, is formed on the light-receiving surface of p-type silicon substrate 2.

Next, as shown in Fig. 4(f), light-receiving surface electrode 8 is formed on the light-receiving surface of p-type silicon substrate 2, and rear electrode 9 is formed on the rear surface of p-type silicon substrate 2. Light-receiving surface electrode 8 and rear electrode 9 are each formed by, for example, printing a conductive paste by the screen printing method and then firing the conductive paste. Light-receiving surface electrode 8 is formed such that a constituent of the conductive paste breaks through antireflection film 7 during firing of the conductive paste to come into contact with n-type impurity second diffusion region 6.

Then, the four sides of p-type silicon substrate 2 are cut off by a dicer or the like to achieve junction isolation, so that solar cell 1 of the first embodiment is formed.

In solar cell 1 of the first embodiment having the structure as described above, n-type impurity second diffusion regions 6 are arranged spaced apart from one another, and subgrid electrode 10 of light-receiving surface electrode 8 is connected to the plurality of n-type impurity second diffusion regions 6 in its longitudinal direction. Therefore, even if a displacement occurs between one n-type impurity second diffusion region 6 and subgrid electrode 10, connection with subgrid electrode 10 can be ensured by other n-type impurity second diffusion regions 6, which can suppress a reduction in conversion efficiency that would be caused by a displacement of light-receiving surface electrode 8 of solar cell 1 having, on the light-receiving surface, n-type impurity first diffusion region 5 having a low n-type impurity concentration for suppressing recombination and n-type impurity second diffusion regions 6 having a high n-type impurity concentration for suppressing an increase in contact resistance with light-receiving surface electrode 8.

Next, in solar cell 1 of the first embodiment, in order to suppress recombination of carriers in the light-receiving surface while reducing the contact resistance between subgrid electrode 10 and n-type impurity second diffusion regions 6, characteristics evaluations of the solar cell were conducted with n-type impurity second diffusion regions 6 arranged spaced apart from one another and the length and pitch of n-type impurity second diffusion regions 6 varied.

A schematic enlarged plan view illustrating the relationship between subgrid electrode 10 and n-type impurity second diffusion regions 6 of the solar cell of the first embodiment is shown in Fig. 5(a). Here, the surface shape of n-type impurity second diffusion region 6 shall be rectangular.

Here, a crossing rate Z (%) of n-type impurity second diffusion regions 6 relative to subgrid electrode 10 is defined by an expression (I) below.

$$\text{Crossing rate } Z(\%) = 100 \times X/Y \qquad \dots \text{(I)}$$

In expression (I) above, a length X represents the length of n-type impurity second diffusion regions 6 in longitudinal direction 10a of subgrid electrode 10, as shown in Fig. 5(a). A pitch Y represents the pitch of n-type impurity second diffusion regions 6 between n-type impurity second diffusion regions 6 in longitudinal direction 10a, as shown in Fig. 5(a).

Moreover, as a control, as shown in Fig. 5(b), n-type impurity second diffusion region 6 is formed to have a surface shape of linear shape in conformity with the surface shape of subgrid electrode 10, width A of subgrid electrode 10 is set at 100 $\mu$m, and a width B of n-type impurity second diffusion region 6 is set at 100 $\mu$m.

As the area of n-type impurity second diffusion region 6 except the region in contact with subgrid electrode 10 increases, recombination of carriers in the light-receiving surface will increase, and the short circuit current density ($J_{sc}$) and the open circuit voltage ($V_{oc}$) as characteristics of a solar cell will be smaller.

Then, first, in Fig. 5(a), the area of n-type impurity second diffusion regions 6 except the region in contact with subgrid electrode 10 was reduced, and crossing rate Z at which the short circuit current density and the open circuit voltage approached those of the control shown in Fig. 5(b) was calculated.

Here, results of evaluations of characteristics of the solar cell obtained in the case where pitch Y was kept constant at 1 mm and crossing rate Z was lowered are shown in Table 1. It is noted that F.F. represents the fill factor and $E_{ff}$ represents the conversion efficiency. The $J_{sc}$ value, the $V_{oc}$ value, the F.F. value, and the $E_{ff}$ value of the control are each set at 1.000. Sample No. 1 has length X of 500 $\mu$m (crossing rate Z: 50%), sample No. 2 has length X of 350 $\mu$m (crossing rate Z: 35%), and sample No. 3 has length X of 200 $\mu$m (crossing rate Z: 20%).

[Table 1]

| Sample No. | Condition (pitch Y: 1mm) | $J_{sc}$ | $V_{oc}$ | F.F. | $E_{ff}$ |
|---|---|---|---|---|---|
| 1 | length X: 500$\mu$m (=crossing rate Z: 50%) | 0.994 | 0.998 | 1.003 | 0.995 |
| 2 | length X: 350$\mu$m (=crossing rate Z: 35%) | 0.995 | 0.998 | 0.990 | 0.983 |
| 3 | length X: 200$\mu$m (=crossing rate Z: 20%) | 1.000 | 0.999 | 0.979 | 0.980 |
| Control | | 1.000 | 1.000 | 1.000 | 1.000 |

As shown in Table 1, as crossing rate Z was lowered, that is, length X was decreased, the $J_{sc}$ value and the $V_{oc}$ value were increased, so that the result approaching the control was obtained. On the other hand, in that result, the F.F. value decreased and the influence of the F.F. value was reflected greatly in the $E_{ff}$ value.

This is considered because, although recombination of carriers in the light-receiving surface could be reduced and the $J_{sc}$ value and the $V_{oc}$ value could be increased by reducing the area of n-type impurity second diffusion regions 6 except the region in contact with subgrid electrode 10, a reduction in the area of n-type impurity second diffusion regions 6 in contact with subgrid electrode 10 caused the increased contact resistance between subgrid electrode 10 and n-type impurity second diffusion regions 6, resulting in a decrease in the F.F. value.

From the results shown in Table 1, a result was obtained in which the $J_{sc}$ value and the $V_{oc}$ value were substantially equivalent to those of the control when crossing rate Z was set at 20%. Then, a study for setting crossing rate Z at 20% to bring the F.F. value closer to that of the control was conducted.

Here, the reason for setting crossing rate Z at 20% is because it is considered that the $J_{sc}$ value and the $V_{oc}$ value remain equivalent to those of the control when crossing rate Z is set at less than or equal to 20%.

Next, results of evaluations of characteristics of the solar cell obtained when crossing rate Z was kept constant at 20% and length X and pitch Y were decreased are shown in Table 2. Sample No. 3 has length X of 200 $\mu$m similarly to Table 1, sample No. 4 has length X of 100 $\mu$m, sample No. 5 has length X of 50 $\mu$m, and sample No. 6 has length X of 30 $\mu$m.

[Table 2]

| Sample No. | Condition (crossing rate Z: 20%) | $J_{sc}$ | $V_{oc}$ | F.F. | $E_{ff}$ |
|---|---|---|---|---|---|
| 3 | length X: 200μm | 1.000 | 0.999 | 0.979 | 0.980 |
| 4 | length X: 100μm | 1.000 | 1.000 | 0.991 | 0.993 |
| 5 | length X: 50μm | 1.000 | 1.000 | 1.000 | 1.000 |
| 6 | length X: 30μm | 1.000 | 1.000 | 1.000 | 1.000 |
| Control | | 1.000 | 1.000 | 1.000 | 1.000 |

As shown in Table 2, in samples No. 5 and No. 6, values equivalent to those of the control were obtained for all of the $J_{sc}$ value, the $V_{oc}$ value, the F.F. value, and the $E_{ff}$ value. Therefore, the results shown in Table 2 reveal that, as shown in Fig. 5(a), in the structure in which the surface shape of n-type impurity second diffusion regions 6 is rectangular, the longitudinal direction of n-type impurity second diffusion regions 6 crosses longitudinal direction 10a of subgrid electrode 10, and further, n-type impurity second diffusion regions 6 are arranged at predetermined pitch Y along longitudinal direction 10a, the $J_{sc}$ value, the $V_{oc}$ value, the F.F. value, and the $E_{ff}$ value similar to those of the control can be obtained in the case where length X of n-type impurity second diffusion regions 6 in longitudinal direction 10a of subgrid electrode 10 is less than or equal to 50 μm. Therefore, the $E_{ff}$ value of conversion efficiency equivalent to that of the control can be obtained while maintaining the $J_{sc}$ value and the $V_{oc}$ value and suppressing a reduction in the F.F. value.

As described above, in the solar cell of the first embodiment, by making the width of n-type impurity second diffusion regions 6 wider than the width of subgrid electrode 10 to connect subgrid electrode 10 within the width of n-type impurity second diffusion regions 6 as well as arranging a plurality of n-type impurity second diffusion regions 6 spaced apart from one another along longitudinal direction 10a of subgrid electrode 10, it is possible to suppress a reduction in conversion efficiency that would be caused by a displacement of light-receiving surface electrode 8 of solar cell 1 having, on the light-receiving surface, n-type impurity first diffusion region 5 having a low n-type impurity concentration for suppressing recombination and n-type impurity second diffusion regions 6 having a high n-type impurity concentration for suppressing an increase in contact resistance with light-receiving surface electrode 8.

<Second Embodiment>

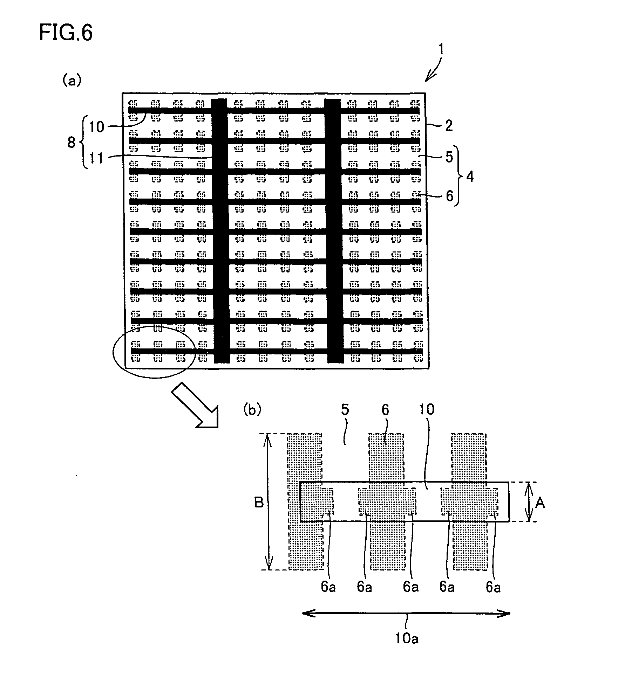

A schematic plan view of a p-type silicon substrate as seen from the light-receiving surface side with an antireflection film formed on the light-receiving surface of a solar cell of a second embodiment having been removed is shown in Fig. 6(a), and a schematic enlarged plan view of and around an end of a subgrid electrode is shown in Fig. 6(b).

Here, as shown in Fig. 6(b), the solar cell of the second embodiment is characterized in that the surface shape of n-type impurity second diffusion region 6 is a shape having a protruding portion 6a protruding in longitudinal direction 10a of subgrid electrode 10 rather than the rectangular shape extended in the direction orthogonal to longitudinal direction 10a of subgrid electrode 10.

In the solar cell of the second embodiment as well, as shown in Fig. 6(b), since n-type impurity second diffusion regions 6 adjacent to each other in longitudinal direction 10a of subgrid electrode 10 are arranged not to be in contact with each other, subgrid electrode 10 will be connected to a plurality of n-type impurity second diffusion regions 6 having width B wider than width A of subgrid electrode 10 in longitudinal direction 10a thereof. Here, width A of subgrid electrode 10 can be 100 μm, for example, and width B of n-type impurity second diffusion regions 6 can be 500 μm, for example.

Therefore, in the solar cell of the second embodiment as well, even if a displacement occurs between one n-type impurity second diffusion region 6 and subgrid electrode 10, connection with subgrid electrode 10 can be ensured by other n-type impurity second diffusion regions 6, which can suppress a reduction in conversion efficiency that would be caused by a displacement of light-receiving surface electrode 8 of solar cell 1 having, on the light-receiving surface, n-type impurity first diffusion region 5 having a low n-type impurity concentration for suppressing recombination and n-type impurity second diffusion region 6 having a high n-type impurity concentration for suppressing an increase in contact resistance with light-receiving surface electrode 8.

The description of the present embodiment except the above is similar to that of the first embodiment, and description thereof will not be repeated.

<Third Embodiment>

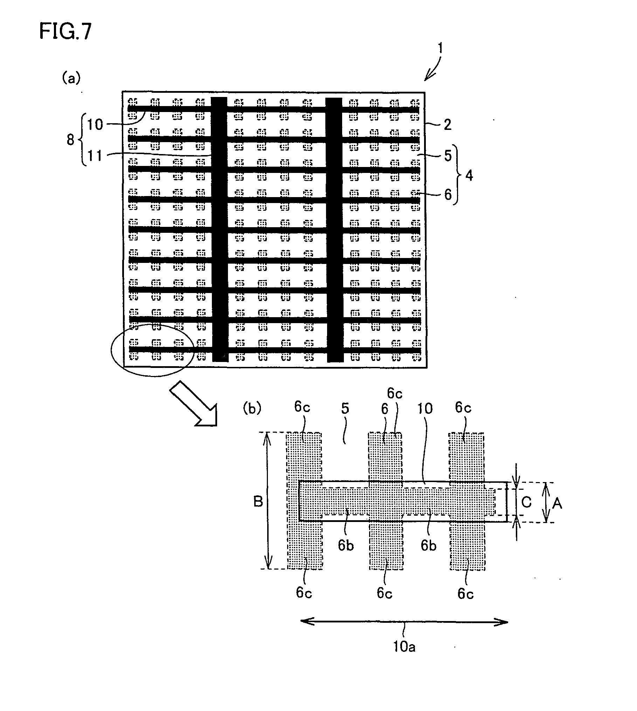

A schematic plan view of a p-type silicon substrate as seen from the light-receiving surface side with an antireflection film formed on the light-receiving surface of a solar cell of a third embodiment having been removed is shown in Fig. 7(a), and a schematic enlarged plan view of and around an end of a subgrid electrode shown in Fig. 7(a) is shown in Fig. 7(b).

As shown in Fig. 7(b), the solar cell of the third embodiment is characterized in that n-type impurity second diffusion regions 6 are coupled to one another in longitudinal direction 10a of subgrid electrode 10 and that a coupling portion 6b of n-type impurity second diffusion regions 6 has a width C narrower than width A of subgrid electrode 10.

In addition, in the solar cell of the third embodiment, as shown in Fig. 7(b), n-type impurity second diffusion region 6 has a protruding portion 6c protruding in the direction orthogonal to longitudinal direction 10a of subgrid electrode 10.

In the solar cell of the third embodiment, as shown in Fig. 7(b), subgrid electrode 10 will be connected to n-type impurity second diffusion regions 6 having width B wider than width A of subgrid electrode 10 in longitudinal direction 10a. Here, width A of subgrid electrode 10 can be 100 $\mu$m, for example, and width B of n-type impurity second diffusion regions 6 can be 500 $\mu$m, for example.

Therefore, in the solar cell of the second embodiment as well, even if a displacement occurs between coupling portions 6b of n-type impurity second diffusion regions 6 and subgrid electrode 10, connection with subgrid electrode 10 can be ensured by protruding portions 6c of n-type impurity second diffusion regions 6, which can suppress a reduction in conversion efficiency that would be caused by a displacement of light-receiving surface electrode 8 of solar cell 1 having, on the light-receiving surface, n-type impurity first diffusion region 5 having a low n-type impurity concentration for suppressing recombination and n-type impurity second diffusion regions 6 having a high n-type impurity concentration for suppressing an increase in contact resistance with light-receiving surface electrode 8.

The description of the present embodiment except the above is similar to those of the first and second embodiments, and description thereof will not be repeated.

<Fourth Embodiment>

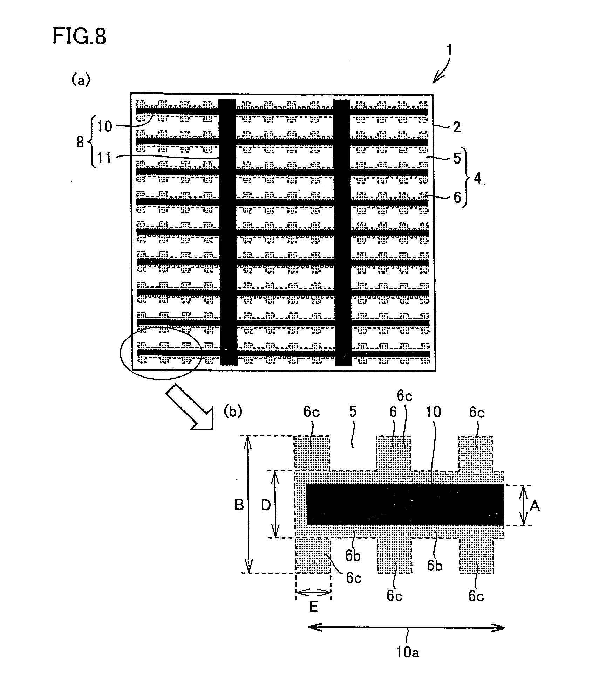

A schematic plan view of a p-type silicon substrate as seen from the light-receiving surface side with an antireflection film formed on the light-receiving surface of a solar cell of a fourth embodiment having been removed is shown in Fig. 8(a), and a schematic enlarged plan view of and around an end of a subgrid electrode shown in Fig. 8(a) is shown in Fig. 8(b).

The solar cell of the fourth embodiment is characterized in that coupling portion 6b coupling n-type impurity second diffusion regions 6 along longitudinal direction 10a of subgrid electrode 10 has a width D wider than width A of subgrid electrode 10.

In the solar cell of the fourth embodiment, as shown in Fig. 8(b), subgrid electrode 10 will be connected to n-type impurity second diffusion regions 6 having width B wider than width A of subgrid electrode 10 in longitudinal direction 10a. Here, width A of subgrid electrode 10 can be 100 $\mu$m, for example, width B of n-type impurity second diffusion regions 6 can be 500 $\mu$m, for example, width D of coupling portion 6b of n-type impurity second diffusion regions 6 can be 350 $\mu$m, for example, and a width E of protruding portion 6c protruding in the direction orthogonal to longitudinal direction 10a of subgrid electrode 10 can be made narrower than in the third embodiment.

Therefore, in the solar cell of the fourth embodiment as well, even if a displacement occurs between coupling portions 6b of n-type impurity second diffusion regions 6 and subgrid electrode 10, connection with subgrid electrode 10 can be ensured by protruding portions 6c of n-type impurity second diffusion regions 6, which can suppress a reduction in conversion efficiency that would be caused by a displacement of light-receiving surface electrode 8 of solar cell 1 having, on the light-receiving surface, n-type impurity first diffusion region 5 having a low n-type impurity concentration for suppressing recombination and n-type impurity second diffusion region 6 having a high n-type impurity concentration for suppressing an increase in contact resistance with light-receiving surface electrode 8.

The description of the present embodiment except the above is similar to those of the first to third embodiments, and description thereof will not be repeated.

It is noted that, although the above first to fourth embodiments have described the case where p-type silicon substrate 2 is used, it is also possible to use an n-type silicon substrate instead of p-type silicon substrate 2. When the n-type silicon substrate is used, the diffusion region on the light-receiving surface side will be a p-type impurity diffusion region, the p-type impurity diffusion region will be made of a p-type impurity first diffusion region and a p-type impurity second diffusion region, and the concentration of a p-type impurity in the surface of the p-type impurity first diffusion region will be lower than the concentration of the p-type impurity in the surface of the p-type impurity second diffusion region.

It should be understood that the embodiments disclosed herein are illustrative and non-restrictive in every respect. The scope of the present invention is defined by the claims not by the description above, and is intended to include any modification within the meaning and scope equivalent to the terms of the claims.

INDUSTRIAL APPLICABILITY

The present invention can be applied to a solar cell, and more particularly to a solar cell having, on the light-receiving surface, an impurity diffusion region having a low impurity concentration for suppressing recombination and an impurity diffusion region having a high impurity concentration for suppressing an increase in contact resistance with a light-receiving surface electrode.

REFERENCE SIGNS LIST

1 solar cell; 2 p-type silicon substrate; 3 uneven structure; 4 n-type impurity diffusion region; 5 n-type impurity first diffusion region; 6 n-type impurity second diffusion region; 6a, 6c protruding portion; 6b coupling portion; 7 antireflection film; 8 light-receiving surface electrode; 9 rear electrode; 10 subgrid electrode; 10a longitudinal direction; 51 acid-resistant mask; 201 solar cell; 202 p-type silicon substrate; 203 uneven structure; 204 n-type impurity diffusion region; 205 n-type impurity first diffusion region; 206 n-type impurity second diffusion region; 207 antireflection film; 208 light-receiving surface electrode; 209 rear electrode; 210 subgrid electrode; 211 main grid electrode; 251 acid-resistant mask.

**Claims**

1. A solar cell (1) comprising:

    a silicon substrate (2) containing an impurity of a first conductivity type;
    a diffusion region (4) containing an impurity of a second conductivity type provided on a light-receiving surface side of said silicon substrate (2); and
    a light-receiving surface electrode (8) provided on the light-receiving surface side of said diffusion region (4), wherein
    said diffusion region (4) has a first diffusion region (5) and second diffusion regions (6),
    surfaces of said second diffusion regions (6) are higher in concentration of the impurity of said second conductivity type than a surface of said first diffusion region (5),
    said second diffusion regions (6) are arranged spaced apart from one another, and
    said light-receiving surface electrode (8) is connected to a plurality of said second diffusion regions (6).

2. The solar cell (1) according to claim 1, wherein
said light-receiving surface electrode (8) is formed of a main grid electrode (11) and a subgrid electrode (10), and said subgrid electrode (10) is connected to the plurality of said second diffusion regions (6).

3. The solar cell (1) according to claim 2, wherein said subgrid electrode (10) crosses said main grid electrode (11).

4. The solar cell (1) according to any one of claims 1 to 3, wherein said second diffusion regions (6) have a rectangular shape.

5. The solar cell (1) according to claim 4, wherein, when a crossing rate Z of said second diffusion regions (6) is expressed by the following expression (I):

$$\text{the crossing rate } Z\ (\%) = 100 \times X/Y \quad ... \text{ (I)}$$

where X represents a length of said second diffusion regions (6) in a longitudinal direction of said subgrid electrode (10), and Y represents a pitch between said second diffusion regions (6) in the longitudinal direction of said subgrid electrode (10),
said crossing rate Z of said second diffusion regions (6) is less than or equal to 20%.

6. The solar cell (1) according to claim 4 or 5, wherein said second diffusion regions (6) each have a protruding portion (6a) protruding in a longitudinal direction of said subgrid electrode (10).

7. A solar cell (1) comprising:

a silicon substrate (2) containing an impurity of a first conductivity type;

a diffusion region (4) containing an impurity of a second conductivity type provided on a light-receiving surface side of said silicon substrate (2); and

a light-receiving surface electrode (8) provided on the light-receiving surface side of said diffusion region (4), wherein

said diffusion region (4) has a first diffusion region (5) and second diffusion regions (6),

surfaces of said second diffusion regions (6) are higher in concentration of the impurity of said second conductivity type than a surface of said first diffusion region (5),

said light-receiving surface electrode (8) is formed of a main grid electrode (11) and a subgrid electrode (10),

said second diffusion regions (6) have regions in contact with said subgrid electrode (10), and

said second diffusion regions (6) each have a protruding portion (6c) protruding in a direction orthogonal to a longitudinal direction of said subgrid electrode (10).

**8.** The solar cell (1) according to claim 7, wherein said subgrid electrode (10) crosses said main grid electrode (11).

**9.** The solar cell (1) according to any one of claims 1 to 8, wherein said second conductivity type is an n-type.

FIG.1

FIG.2

# FIG.3

(a)

(b)

EP 2 587 548 A1

FIG.4

(a)

(d)

(b)

(e)

(c)

(f)

FIG.5

(a)

(b)

14

# FIG.6

(a)

(b)

## FIG.7

(a)

(b)

## FIG.8

(a)

(b)

FIG.9

FIG.10

# FIG.11

(a)

(b)

(c)

(d)

(e)

(f)

## FIG.12

(a)

(b)   205   206   210

<div align="center">**INTERNATIONAL SEARCH REPORT**</div>

| | International application No. |
|---|---|
| | PCT/JP2011/064048 |

**A. CLASSIFICATION OF SUBJECT MATTER**
*H01L31/04(2006.01)i*

According to International Patent Classification (IPC) or to both national classification and IPC

**B. FIELDS SEARCHED**

Minimum documentation searched (classification system followed by classification symbols)
H01L31/04

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2011 |
| Kokai Jitsuyo Shinan Koho | 1971–2011 | Toroku Jitsuyo Shinan Koho | 1994–2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2005-123447 A (Shin-Etsu Handotai Co., Ltd.), 12 May 2005 (12.05.2005), paragraphs [0006], [0019] to [0023], [0044] (Family: none) | 1-8 |
| A | JP 11-508088 A (Fraunhofer-Gesellschaft zur Foerderung der Angewandten Forschung e.V.), 13 July 1999 (13.07.1999), entire text; all drawings & US 6147297 A & WO 1997/001189 A1 & DE 19522539 A1 & AU 6120896 A & AU 716866 B | 1-8 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 July, 2011 (04.07.11) | 12 July, 2011 (12.07.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2011/064048

| C (Continuation). DOCUMENTS CONSIDERED TO BE RELEVANT | | |
|---|---|---|
| Category* | Citation of document, with indication, where appropriate, of the relevant passages | Relevant to claim No. |
| A | JP 64-13774 A (Hitachi, Ltd.), 18 January 1989 (18.01.1989), entire text; all drawings (Family: none) | 1-8 |
| A | JP 2010-56241 A (Mitsubishi Electric Corp.), 11 March 2010 (11.03.2010), entire text; all drawings (Family: none) | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **THOMAS LAUERMANN et al.** INSECT: AN INLINE SELECTIVE EMITTER CONCEPT WITH HIGH EFFICIENCIES AT COMPETITIVE PROCESS COSTS IMPROVED WITH INKJET MASKING TECHNOLOGY. *24th EU PVSEC Hamburg,* 21 September 2009